# EUROPEAN PATENT SPECIFICATION

(11) **EP 4 202 518 B1**
(45) Date of publication and mention of the grant of the patent: **15.10.2025**
(21) Application number: 22207949.3
(22) Date of filing: 17.11.2022
(51) Int. Cl.: G02B 6/42

(54) **ELECTRONIC DEVICE INCLUDING A GRIN LENS**
ELEKTRONISCHE VORRICHTUNG MIT GRIN-LINSE
DISPOSITIF ÉLECTRONIQUE COMPRENANT UNE LENTILLE GRIN

(30) Priority: 21.12.2021 US 202117557630
(43) Date of publication of application: 28.06.2023
(73) Proprietor: Intel Corporation, Santa Clara, CA 95054 (US)
(72) Inventor: Li, Xiaoqian, Chandler, 85248 (US); Karhade, Omkar, Chandler, 85248 (US); Hosseini, Kaveh, Livermore, 94550 (US); Chiu, Chia-Pin, Tempe, 85284 (US)
(74) Representative: Goddar, Heinz J.

(56) References cited:
- US-A1- 2001 033 712
- US-A1- 2014 147 079
- US-A1- 2015 219 989

## Description

### TECHNICAL FIELD

This document pertains generally, but not by way of limitation, to an electronic device including one or more integrated circuits.

### BACKGROUND

In an approach, fiber-optic communications includes transmitting light through one or more optical fibers (e.g., glass, plastic, or the like). The optical fiber may be coupled with a photonic integrated circuit ("PIC"). For instance, the optical fiber may be coupled with an edge coupler of the PIC. The optical fiber may transmit light from a source to the edge coupler of the PIC. The photonic integrated circuit may convert light to an electronic signal. In this approach, misalignment between the optical fiber (coupled to the PIC) and the edge connector may result in loss of one or more of the PIC or the optical fiber.

US 2014/147079 A1 discloses an electronic device according to the preamble of claim 1.

US 2001/033712 A1 discloses a GRIN lens and a cladding layer coupled about the parameter edge of the GRIN lens.

US 2015/219989 A1 discloses technological background.

### SUMMARY OF THE INVENTION

The present invention provides an electronic device according to claim 1.

The dependent claims relate to special embodiments thereof.

### BRIEF DESCRIPTION OF THE DRAWINGS

In the drawings, which are not necessarily drawn to scale, like numerals may describe similar components in different views. Like numerals having different letter suffixes may represent different instances of similar components. The drawings illustrate generally, by way of example, but not by way of limitation, various embodiments discussed in the present document.
- Figure 1: shows a schematic diagram of an example of an electronic device.
- Figure 2: shows an example of a GRIN lens including a fiber.
- Figure 3: shows another example of the electronic device of Figure 1.
- Figure 4: shows an example of an electronic system.
- Figure 5: shows a system level diagram, depicting an example of an electronic device (e.g., system) including one or more of the electronic device of Figures 1 or 3 or the electronic system of Figure 4 as described in the present disclosure.

### DETAILED DESCRIPTION

The present inventors have recognized, among other things, that a problem to be solved may include optically interconnecting an optical fiber with a photonic integrated circuit ("PIC"). In some approaches, misalignment between the optical fiber and the PIC may result in loss of one or more of the PIC or the optical fiber. For instance, the PIC may include an optical interconnect (e.g., a waveguide, edge connector, or the like). Misalignment between the optical fiber and the optical interconnect may result in loss of one or more of the PIC or the optical fiber. In another approach, the photonic signal diverges as it travels between the PIC and the optical fiber. Accordingly, the integrity of the photonic signal may be degraded by divergence of the photonic signal during transmission between the PIC and the optical fiber. For example, the photonic signal may degrade as it travels to the point where the photonic signal is lost before reception at one or more of the PIC or optical fiber.

The present subject matter may help provide a solution to this problem, such as with a lens assembly. An electronic device includes the lens assembly. The lens assembly may focus a photonic signal transmitted by the electronic device. For instance, the lens assembly may focus a photonic signal transmitted between the PIC and the optical fiber.

The electronic device includes a substrate. The substrate includes one or more electrical traces and a dielectric material. The electronic device includes the photonic integrated circuit. The PIC is coupled with the substrate. The substrate includes a cavity. The cavity is configured to receive one or more components of the electronic device. For instance, the cavity may help align a lens assembly with the PIC.

The PIC includes one or more optical interconnects. The PIC is configured to communicate a photonic signal with one or more optical fibers. For instance, the optical interconnects may communicate with the optical fibers to transmit the photonic signal to (or receive the photonic signal from) the optical fibers. The PIC is configured to process the photonic signal into an electronic signal. For instance, the PIC may convert one or more photons into an electrical current. The PIC may convert an electrical current into one or more photons. The PIC extends between a first end and a second end, and the first end of the PIC extends into the cavity.

The electronic device includes an electronic integrated circuit ("EIC"). The EIC is coupled with the substrate. Accordingly, one or more of the EIC or the PIC may communicate with the substrate. The electronic integrated circuit communicates with the photonic integrated circuit. The EIC is configured to transmit an electrical signal to the PIC or to receive the electrical signal from the PIC. In an example, the EIC may generate an electronic signal. The EIC may transmit the electronic signal to the PIC. The PIC may process the electronic signal into a photonic signal. The PIC may transmit the photonic signal to one or more optical fibers. In another example, the PIC may receive the photonic signal from the optical fibers. The PIC may process the photonic signal into an electronic signal. The PIC may transmit the electronic signal to the EIC. Accordingly, the PIC may communicate with one or more of the EIC, the optical fibers, or the substrate.

As described herein, the electronic device includes a lens assembly. The lens assembly includes a spherical lens. The lens assembly includes at least one gradient refractive index ("GRIN") lens in the cavity. For instance, the GRIN lens may be coupled with the photonic integrated circuit. The optical interconnects may cooperate with the lens assembly to communicate the photonic signal with one or more optical fibers. For example, the photonic signal may be communicated between the PIC and the optical fibers using the GRIN lens. In another example, the optical interconnects are aligned with the lens assembly. For instance, the photonic signal may be transmitted from the optical interconnects and through the GRIN lens. The photonic signal may be transmitted from the GRIN lens to the optical fibers. In yet another example, the photonic signal may be transmitted from the optical fibers to the GRIN lens. The photonic signal may be transmitted from the GRIN lens to the optical interconnects. Accordingly, the photonic signal may be transmitted through the GRIN lens during communication between the photonic integrated circuit and the one or more optical fibers.

In an example, the lens assembly cooperates with the PIC to optically interconnect the PIC with an optical fiber. For example, the lens assembly may focus (e.g., collimate, concentrate, direct, refract, bend, gather, collect, converge, narrow, sharpen, diverge, broaden, expand, or the like) the photonic signal communicated between the PIC and the optical fiber. Accordingly, the lens assembly may cooperate with one or more of the PIC or the optical fiber to optically interconnect the PIC with the optical fiber. For instance, the GRIN lens may focus the photonic signal to increase the distance the photonic signal travels to enhance before the photonic signal degrades to a point of being lost. The GRIN lens may focus the photonic signal to facilitate alignment between the PIC and the optical fibers. In another example, the GRIN lens may increase the distance the photonic signal travels while maintaining integrity of the photonic signal. In yet another example, the optical interconnect of the PIC may transmit the photonic signal through the GRIN lens. The GRIN lens may focus the photonic signal, for instance to reduce divergence of the photonic signal as the photonic signal is transmitted to the optical fibers. In another example, the lens assembly may reduce degradation of the photonic signal during transmission of the photonic signal between components of the electronic device. For instance, the lens assembly may reduce loss of the photonic signal before reception at one or more of the PIC or the optical fiber. Accordingly, the lens assembly may improve the performance of the electronic device, for example by enhancing transmission of a photonic signal between components of the electronic device. The electronic device further comprises a fiber array unit, FAU, including the spherical lens, and the FAU is configured for coupling with the one or more optical fibers.

This overview is intended to provide an overview of subject matter of the present patent application. It is not intended to provide an exclusive or exhaustive explanation of the present patent application. The Detailed Description continues, and provides further information about the present patent application.

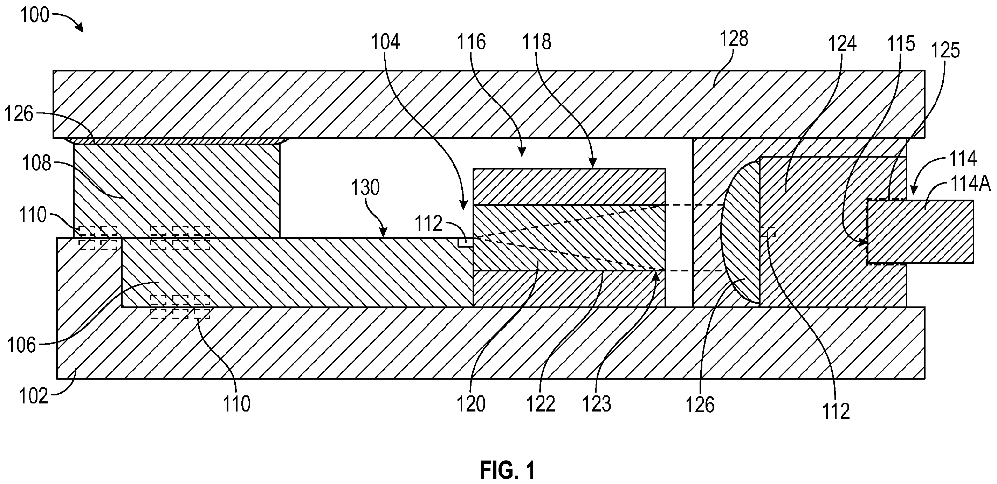

Figure 1 shows a schematic diagram of an electronic device 100 according to the claimed invention.

The electronic device 100 may facilitate fiber-optic communications. For instance, the electronic device 100 may receive a photonic signal transmitted over one or more optical fibers. The electronic device 100 may process the photonic signal into an electronic signal. The electronic device 100 may communicate the electronic signal to other components of the electronic device 100.

The electronic device 100 includes a substrate 102. The substrate 102 comprises a cavity 104. In an example, one or more components of the electronic device 100 may be coupled with the substrate 102. For instance, the one or more components may be located in the cavity 104 and coupled with the substrate 102. The substrate 100 may communicate signals between the components of the electronic device 100.

The electronic device 100 includes a photonic integrated circuit 106 ("PIC 106"). In an example, the photonic integrated circuit 106 may include one or more of indium phosphide, or silicon nitride (however the present subject matter is not so limited). The photonic integrated circuit 106 may process a photonic signal into an electronic signal. In another example, the PIC 106 may process (e.g., convert, change, transform, translate, transduce, or the like) the electronic signal into the photonic signal. For instance, the PIC 100 may process the photonic signal to correspond with the electronic signal. In another example, one or more of the photonic signal or the electronic signal may correspond with data (e.g., an analog signal, digital signal, or the like).

The electronic device 100 includes an electronic integrated circuit 108 ("EIC 108"). In an example, the electronic integrated circuit 108 may include silicon (however the present subject matter is not so limited). The EIC 108 may be coupled with the PIC 106. For instance, the electronic integrated circuit 108 may communicate with the photonic integrated circuit 106. In an example, the EIC 108 may communicate the electronic signal with the PIC 106. In another example, the EIC 108 may communicate with other integrated circuits, including (but not limited to) a CPU, memory FPGA, or switch ASIC. For instance, the EIC 108 and the other integrated circuits may be included in a package. In another example, the EIC 108 communicates with the other integrated circuits using an interconnect bridge.

Additionally, the electronic device 100 may include one or more electrical interconnects 110. The electrical interconnects 110 may facilitate communication of the electronic signal between components of the electronic device 100. For instance, the EIC 108 may communicate the electronic signal with the PIC 106 using the electrical interconnects 110. In yet another example, the EIC 108 may communicate the electronic signal with the substrate 102 using the electrical interconnects 110. In still yet another example, the PIC 108 may communicate the electronic signal with substrate 102 using the electrical interconnects 110.

Referring to Figure 1, the photonic integrated circuit 106 includes one or more optical interconnects 112. The optical interconnects 112 may facilitate communication of the photonic signal. For instance, the optical interconnects 112 may communicate with one or more optical fibers 114 to transmit a photonic signal to (or receive the photonic signal from) the optical fibers 114. In another example, the optical interconnects 112 may include one or more of a waveguide, edge connector, optical sensor, diode, laser, or the like.

The electronic device 100 includes a lens assembly 116. The lens assembly 116 may focus a photonic signal transmitted by the electronic device 100. For instance, the lens assembly 116 may focus a photonic signal transmitted between the PIC 106 and the optical fibers 114. The lens assembly 116 includes a gradient refractive index lens 118 in the cavity.

For instance, the gradient refractive index lens 118 may comprise a gradient refractive index optical fiber. For example, the lens assembly 116 may include a fiber 120 (e.g., core, guide, transmission medium, or the like) The fiber 120 may include (but is not limited to) glass (e.g., silica, or the like) or a polymer (e.g., plastic, or the like). The lens assembly 116 may include a cladding layer 122 coupled with the fiber 120. For instance, the cladding layer 122 may be coupled about a perimeter edge 123 of the fiber 122. In some examples, the cladding layer 122 has a lower refractive index than the fiber 120.

The gradient refractive index ("GRIN") lens 118 may be coupled with the photonic integrated circuit 106. For example, the photonic signal may be communicated between the PIC 106 and the optical fibers 114 using the GRIN lens 118. In an example, the optical interconnects 112 may cooperate with the lens assembly 116 to communicate the photonic signal with the one or more optical fibers 114. In another example, the optical interconnects 112 may be aligned with the lens assembly 116. For instance, the photonic signal may be transmitted from the optical interconnects 112 and through the GRIN lens 118. The photonic signal may be transmitted from the GRIN lens 118 to the optical fibers 114. In yet another example, the photonic signal may be transmitted from the optical fibers 114 to the GRIN lens 118. The photonic signal may be transmitted from the GRIN lens 118 to the optical interconnects 112. Accordingly, the photonic signal may be transmitted through the GRIN lens 118 during communication between the photonic integrated circuit 106 and the one or more optical fibers 114.

Referring to Figure 1, the electronic device 100 includes a fiber array unit 124. The fiber array unit 124 couples with the one or more optical fibers 114. In an example, fiber array unit 124 may be coupled with an end 115 of the one or more optical fibers 114. In another example, the fiber array unit 124 may include a fiber socket 125. In yet another example, the fiber socket 125 may receive the end 115 of the optical fiber 114A. Accordingly, the one or more optical fibers 114 may couple with the fiber array unit 124.

In another example, the fiber array unit 114 aligns the optical fibers 114 with the optical interconnects 112 of the photonic integrated circuit 106. In yet another example, the fiber array unit 124 separates the optical fibers 114 by a specified pitch. For instance, the fiber array unit may space a first optical fiber at a first pitch (e.g., distance, dimension, orientation, pattern, or the like) from a second optical fiber. In still yet another example, the fiber array unit may arrange the optical fibers in a specified configuration. For instance, coupling the optical fibers 114 with the fiber array unit 124 may arrange the optical fibers in a line. In another example, coupling the optical fibers 114 with the fiber array unit 124 may arrange the optical fibers in a grid. Accordingly, coupling the optical fibers 120 with the fiber array unit 124 may secure the optical fibers in a specified configuration. For example, coupling the optical fibers 114 with the fiber array unit 124 may align the optical fibers 114 with the optical interconnects 112 of the photonic integrated circuit 106. Thus, the fiber array unit 124 may cooperate with the optical fibers 114 and the PIC 106 to facilitate communication of the photonic signal between the optical fibers 114 and the PIC 106.

As described herein, the electronic device 100 includes the lens assembly 116. The lens assembly includes a spherical lens 126. The spherical lens 126 may focus the photonic signal communicated between the PIC 106 and the optical fibers 114. In an example, the spherical lens 126 may be coupled with the fiber array unit 124. In another example, the spherical lens 126 may be aligned with the optical fibers 114. The fiber array unit 124 includes at least one of the spherical lens 126 aligned with an individual optical fiber of the one or more optical fibers 114. In an example, Figure 1 shows optical fiber 114A aligned with the lens assembly 116 (including the spherical lens 126). In another example, the fiber array unit 124 includes the one or more optical interconnects 112. The lens assembly 116 may be aligned with the optical interconnects 112 of the fiber array unit 124. For instance, the optical interconnects 112 may communicate the photonic signal between the optical fibers 114 and the lens assembly 116 (e.g., the spherical lens 126, or the like). Thus, the lens assembly 116 cooperates with one or more of the PIC 106 or the optical fibers 114 to communicate the photonic signal between the PIC 106 and the optical fibers 114.

Referring to Figure 1, the electronic device 100 may include a heat sink, for instance an integrated heat spreader 128. The integrated heat spreader 128 may enhance dissipation of heat from the components of the electronic device 100. For instance, the integrated heat spreader 128 may be coupled with one or more of the EIC 108, the PIC 106, the lens assembly 116, or the fiber array unit 124. In some examples, a thermal interface material 129 is coupled between the integrated heat spreader 128 and components of the electronic device 100. For instance, the thermal interface material 129 may enhance heat transfer between the EIC 108 and the integrated heat spreader 128. Accordingly, the electronic device 100 may include the integrated heat spreader 128, for instance to enhance dissipation of heat from components of the electronic device 100.

As described herein, the GRIN lens 118 may be coupled with the photonic integrated circuit 106. For instance, the PIC 106 may include a first surface 130 (e.g., top surface, or the like). The PIC may include a second surface 132 (e.g., bottom surface, or the like). In an example, an edge 134 the first surface 130 and the second surface 132. For instance, the edge 134 of the PIC 106 may be located a first end 136 of the PIC 106. In some examples, the GRIN lens 118 may be coupled with the edge 134 of the PIC 106. The GRIN lens 118 may form a direct interface with the PIC 106. For instance, the fiber 120 may form a direct interface with the edge 136 of the PIC 106. In another example, the cladding layer 122 of the GRIN lens 118 may be coupled with one or more of the substrate or the PIC 106. The optical interconnects 112 may be located proximate the surface 130. In another example, the optical interconnects 112 may located proximate the edge 134. Accordingly, the optical interconnects 112 may direct the photonic signal transmitted through the GRIN lens 118.

In another example, the EIC 108 may be coupled with a second end 138 of the PIC 106. For instance, Figure 1 shows the EIC 108 coupled with the first surface 130 at the second end 138 of the PIC 106. The cavity 104 of the substrate 102 may receive one or more of the PIC 106, EIC 108, lens assembly 116, or the fiber array unit 124.

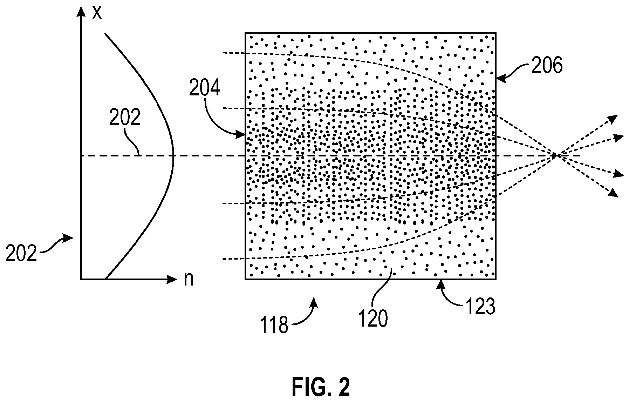

Figure 2 shows an example of the GRIN lens 118 including the fiber 120. Figure 2 includes a plot 200 showing the refractive index (n) with respect to distance (*d*) from a central axis 202 of the GRIN lens 118. As described herein, the GRIN lens 118 focuses a photonic signal (shown in Figure 2 with dashed arrows). In an example, the refractive index (*n*) of the GRIN lens 118 changes in correspondence with the distance (*d*) from the central axis 202. For instance, the plot 200 shows the refractive index (*n*) decreasing in value as the distance (*d*) increases from the central axis 202 of the GRIN lens 118. Figure 2 includes dot stippling showing the change in the refractive index (*n*) of the GRIN lens 118. In another example not belonging to the claimed invention, the refractive index (*n*) may increase in value as the distance (*d*) increases from the central axis 202 of the GRIN lens 118. In yet another example, the refractive index (*n*) of the GRIN lens 118 may decrease from the central axis 202 to the perimeter edge 123 of the GRIN lens 118. In still yet another example, the refractive index (*n*) of the GRIN lens 118 decreases radially from the central axis 202. In a still yet further example, the refractive index (*n*) may decrease along an axis of the GRIN lens 200 (e.g., the central axis 202).

The GRIN lens 118 may include a first lens face 204. The GRIN lens 118 may include a second lens face 206. The first lens face 204 may be opposite the second lens face 206. In an example, one or more of the lens faces 204, 206 may be planar. For instance, the first lens face 204 may extend perpendicularly with respect to the central axis 202. In another example, one or more of the first lens 204 or the second lens 206 may be flat. As described herein, the GRIN lens 118 may form a direct interface with the photonic integrated circuit 106. For instance, the first lens face 204 may form a direct interface with the edge 134 (shown in Figure 1) of the PIC 106. In yet another example, one or more of the first lens 204 or the second lens 206 may be curved.

In an example, the GRIN lens 118 may focus the photonic signal by varying the index of refraction within the GRIN lens 118. For instance, all optical path lengths (e.g., a refractive index multiplied by distance) may be the same in the GRIN lens 118 due to the change in refractive index with respect to the central axis 202. Accordingly, the GRIN lens 118 may focus the photonic signal differently than the spherical lens 126 (shown in Figure 1).

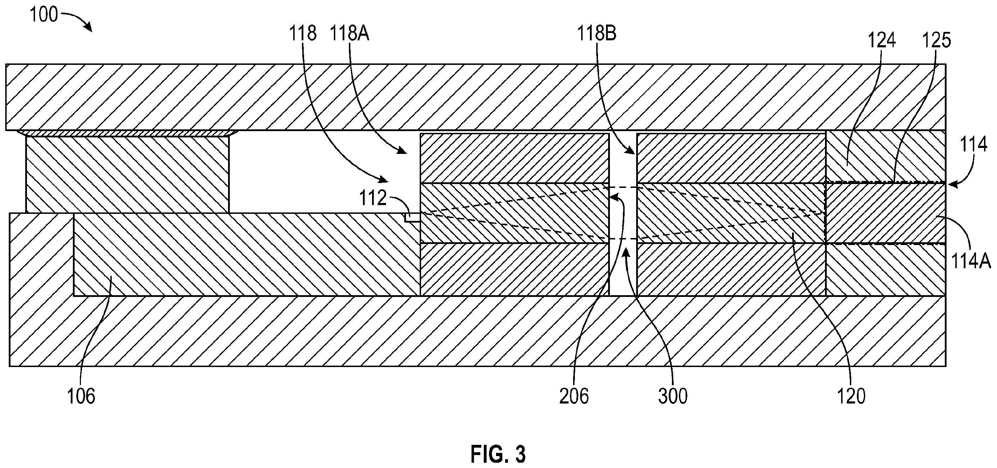

Figure 3 shows another example, not being part of the claimed invention, of the electronic device 100. As described herein, the electronic device 100 may include the lens assembly 116. In an example, the lens assembly 116 may include more than one of the GRIN lenses 118. For instance, a first GRIN lens 118A may be coupled with the PIC 106.

In another example, the electronic device 100 may include a second GRIN lens 118B. For example, the second GRIN lens 118B may be coupled with the fiber array unit 124. The fiber socket 125 may align the optical fibers 114 with the lens assembly 116. For instance, the fiber socket 125 may align the optical fiber 114A with the second GRIN lens 118B. In yet another example, the fiber socket 125 may align the optical fiber 114A with the GRIN lens 118B. For example, the fiber socket may align the optical fiber 114A with the fiber 120 of the GRIN lens 118B. In another example, the end 115 of the optical fibers 114 may form a direct interface with lens assembly 116. For instance, the end 115 of the optical fiber 114A may form a direct interface with the second lens face 206 of the GRIN lens 118B. Accordingly, the GRIN lens 118B may focus a photonic signal communicated with the optical fiber 114A.

In yet another example, the electronic device 100 may transmit the photonic signal between the optical fibers 114 and the photonic integrated circuit 106. For instance, the one or more optical interconnects 112 may transmit the photonic signal to the lens assembly 116. In an example, the optical interconnects may transmit the photonic signal through the first GRIN lens 118A. In another example, the lens assembly 116 may transmit the photonic signal across a transmission gap 300 (e.g., air gap, vacuum, space, or the like). For instance, the transmission gap 300 may separate the first GRIN lens 118A from the second GRIN lens 118B. Accordingly, the electronic device 100 may transmit the photonic signal through the transmission gap 300 during communication between the PIC 106 and the optical fibers 114.

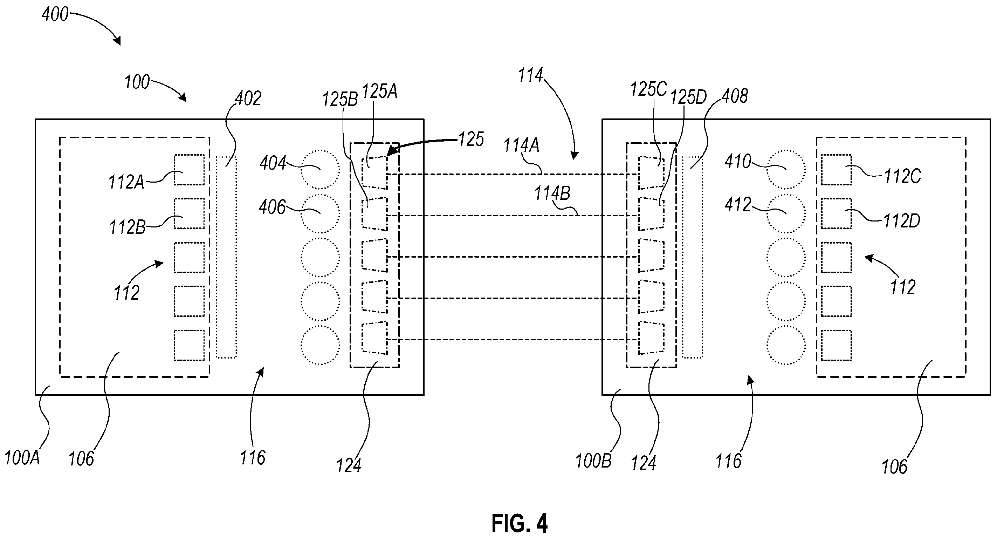

Figure 4 shows an example of an electronic system 400. In an example, the electronic system 400 may include two or more of the electronic device 100. For instance, the electronic system 400 may include a first electronic device 100A. The electronic system 400 may include a second electronic device 100B. The first electronic device 100A may communicate with the second electronic device 100B. For example, the one or more optical fibers 114 may facilitate communication between the first electronic device 100A and the second electronic device 100B. In another example, the electronic system 400 may communicate a photonic signal between the first electronic device 100A and the second electronic device 100B. For instance, the first optical fiber 114A may transmit the photonic signal between the first electronic device 100A and the second electronic device 100B. In another example, a second optical fiber 114B may transmit the photonic signal between the first electronic device 100A and the second electronic device 100B.

The electronic devices 100A, 100B may include the lens assembly 116. In an example, the first electronic device 100A may include one or more of a first lens 402, a second lens 404, or a third lens 406. In another example, the second electronic device 100B may include one or more of a fourth lens 408, a fifth lens 410, or a sixth lens 412. In some examples, one or more of the lenses 402, 404, 406, 408, 410, 412 include a gradient refractive index lens. For instance, the lens 404 may include a GRIN optical fiber. In another example, one or more of the lenses 402, 404, 406, 408, 410, 412 include a spherical lens.

The lens assembly 116 may focus the photonic signal communicated by electronic system 400. In an example, the first lens 402 may be coupled with the PIC 106 of the first electronic device 100A. In another example, a first optical interconnect 112A may be aligned with the first lens 402. A second optical interconnect 112B may be aligned with the first lens 402. The photonic signal communicated by the optical interconnects 112A, 112B of the PIC 106 may be transmitted through the first lens 402. Accordingly, the first lens 402 may be associated with one or more of the optical interconnects 112 of the PIC 106.

In another example, the fiber array unit 124 of the first electronic device 100 may include the second lens 404 and the third lens 406. For instance, the lens 404 may be aligned with a first fiber socket 125A. The lens 406 may be aligned with the second fiber socket 125B. Thus, the lenses 404, 406 may be aligned with individual ones of the fiber sockets 125. In yet another example, a photonic signal communicated by an optical fiber associated with the first fiber socket 125A (e.g., optical fiber 114A, or the like) may be transmitted through the lens 404. In still yet another example, a photonic signal communicated by an optical fiber associated with the second fiber socket 125B (e.g., optical fiber 114B, or the like) may be transmitted through the lens 406. Accordingly, the lenses 404, 406 may be associated with individual ones of the fiber sockets 115 (or individual ones of the fibers 114).

As described herein and referring to Figure 4, the electronic system 400 may include the second electronic device 100B. The second electronic device 100B may include the lenses 408, 410, 412. In an example, the fourth lens 402 may be coupled with the fiber array unit 124 of the second electronic device 100A. In another example, a third fiber socket 125C may be aligned with the lens 408. A fourth fiber socket 125D may be aligned with the lens 408. A photonic signal communicated by an optical fiber associated with the third fiber socket 125C (e.g., optical fiber 114A, or the like) may be transmitted through the lens 408. In still yet another example, a photonic signal communicated by an optical fiber associated with the fourth fiber socket 125D (e.g., optical fiber 114B, or the like) may be transmitted through the lens 408. Accordingly, the fourth lens 402 may be associated with one or more of the fiber sockets 115 (or optical fibers 114 coupled with the fiber array unit 124).

In yet another example, the fifth lens 410 may be coupled with the PIC 106 of the second electronic device 100. The sixth lens 412 may be coupled with the PIC 106 of the second electronic device 100. For example, a third optical interconnect 112C may be aligned with the lens 410. A fourth optical interconnect 112D may be aligned with the lens 412. Accordingly, a photonic signal communicated by the optical interconnects 112D may be transmitted through the lens 410. In another example, a photonic signal communicated by the optical interconnect 112D may be transmitted through the lens 410. Accordingly, the lenses 410, 412 may be associated with individual ones of the optical interconnects 112.

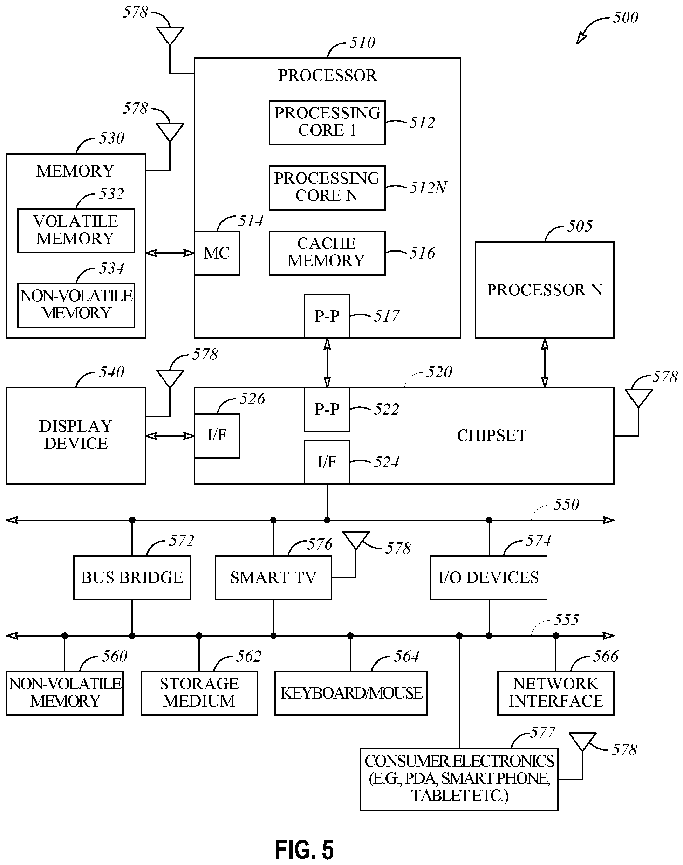

Figure 5 shows a system level diagram, depicting an example of an electronic device (e.g., system) including one or more the electronic device 100 or electronic system 400 as described in the present disclosure. Figure 5 is included to show an example of a higher level device application for the electronic device 100 (or electronic system 400). In one embodiment, system 500 includes, but is not limited to, a desktop computer, a laptop computer, a netbook, a tablet, a notebook computer, a personal digital assistant (PDA), a server, a workstation, a cellular telephone, a mobile computing device, a smart phone, an Internet appliance or any other type of computing device. In some embodiments, system 500 is a system on a chip (SOC) system.

In one embodiment, processor 510 has one or more processor cores 512 and 512N, where 512N represents the Nth processor core inside processor 510 where N is a positive integer. In one embodiment, system 500 includes multiple processors including 510 and 505, where processor 505 has logic similar or identical to the logic of processor 510. In some embodiments, processing core 512 includes, but is not limited to, pre-fetch logic to fetch instructions, decode logic to decode the instructions, execution logic to execute instructions and the like. In some embodiments, processor 510 has a cache memory 516 to cache instructions and/or data for system 500. Cache memory 516 may be organized into a hierarchal structure including one or more levels of cache memory.

In some embodiments, processor 510 includes a memory controller 514, which is operable to perform functions that enable the processor 510 to access and communicate with memory 530 that includes a volatile memory 532 and/or a non-volatile memory 534. In some embodiments, processor 510 is coupled with memory 530 and chipset 520. Processor 510 may also be coupled to a wireless antenna 578 to communicate with any device configured to transmit and/or receive wireless signals. In one embodiment, an interface for wireless antenna 578 operates in accordance with, but is not limited to, the IEEE 802.11 standard and its related family, Home Plug AV (HPAV), Ultra Wide Band (UWB), Bluetooth, WiMax, or any form of wireless communication protocol.

In some embodiments, volatile memory 532 includes, but is not limited to, Synchronous Dynamic Random Access Memory (SDRAM), Dynamic Random Access Memory (DRAM), RAMBUS Dynamic Random Access Memory (RDRAM), and/or any other type of random access memory device. Non-volatile memory 534 includes, but is not limited to, flash memory, phase change memory (PCM), read-only memory (ROM), electrically erasable programmable read-only memory (EEPROM), or any other type of non-volatile memory device.

Memory 530 stores information and instructions to be executed by processor 510. In one embodiment, memory 530 may also store temporary variables or other intermediate information while processor 510 is executing instructions. In the illustrated embodiment, chipset 520 connects with processor 510 via Point-to-Point (PtP or P-P) interfaces 517 and 522. Chipset 520 enables processor 510 to connect to other elements in system 500. In some embodiments of the example system, interfaces 517 and 522 operate in accordance with a PtP communication protocol such as the Intel^{®} QuickPath Interconnect (QPI) or the like. In other embodiments, a different interconnect may be used.

In some embodiments, chipset 520 is operable to communicate with processor 510, 505N, display device 540, and other devices, including a bus bridge 572, a smart TV 576, I/O devices 574, nonvolatile memory 560, a storage medium (such as one or more mass storage devices) 562, a keyboard/mouse 564, a network interface 566, and various forms of consumer electronics 577 (such as a PDA, smart phone, tablet etc.), etc. In one embodiment, chipset 520 couples with these devices through an interface 524. Chipset 520 may also be coupled to a wireless antenna 578 to communicate with any device configured to transmit and/or receive wireless signals.

Chipset 520 connects to display device 540 via interface 526. Display 540 may be, for example, a liquid crystal display (LCD), a plasma display, cathode ray tube (CRT) display, or any other form of visual display device. In some embodiments of the example system, processor 510 and chipset 520 are merged into a single SOC. In addition, chipset 520 connects to one or more buses 550 and 555 that interconnect various system elements, such as I/O devices 574, nonvolatile memory 560, storage medium 562, a keyboard/mouse 564, and network interface 566. Buses 550 and 555 may be interconnected together via a bus bridge 572.

In one embodiment, mass storage device 562 includes, but is not limited to, a solid state drive, a hard disk drive, a universal serial bus flash memory drive, or any other form of computer data storage medium. In one embodiment, network interface 566 is implemented by any type of well-known network interface standard including, but not limited to, an Ethernet interface, a universal serial bus (USB) interface, a Peripheral Component Interconnect (PCI) Express interface, a wireless interface and/or any other suitable type of interface. In one embodiment, the wireless interface operates in accordance with, but is not limited to, the IEEE 802.11 standard and its related family, Home Plug AV (HPAV), Ultra Wide Band (UWB), Bluetooth, WiMax, or any form of wireless communication protocol.

While the modules shown in FIG. 5 are depicted as separate blocks within the system 500, the functions performed by some of these blocks may be integrated within a single semiconductor circuit or may be implemented using two or more separate integrated circuits. For example, although cache memory 516 is depicted as a separate block within processor 510, cache memory 516 (or selected aspects of 516) may be incorporated into processor core 512.

## Claims

1. An electronic device (100), comprising:
a substrate (102) including one or more electrical traces and a dielectric material, the substrate comprising a cavity configured to receive one or more components of the electronic device (100);
a photonic integrated circuit, PIC (106) coupled with the substrate (102), the PIC (106) including one or more optical interconnects (112), wherein:
the PIC (106) is configured to communicate a photonic signal with one or more optical fibers (114) ;
the PIC (106) is configured to process the photonic signal into an electronic signal; and
the PIC (106) extends between a first end and a second end, and the first end of the PIC extends into the cavity;
an electronic integrated circuit ,EIC, (108) coupled with the substrate (102), wherein the EIC (108) is in communication with the PIC (106), and the EIC is configured to transmit the electronic signal to the PIC (106) or to receive the electronic signal from the PIC (106); and
a lens assembly (116) including at least one gradient refractive index GRIN, lens (118), wherein:
the GRIN lens (118) has a central longitudinal axis and a perimeter edge; and
a refractive index of the GRIN lens (118) decreases from the central longitudinal axis to the perimeter edge (123);
**characterized in that**
it further comprises a fiber array unit, FAU, (124) including a spherical FAU lens (126), wherein the FAU (124) is configured for coupling with the one or more optical fibers (114, 114A); and
that the GRIN lens (118) is in the cavity.

2. The electronic device of claim 1, wherein the GRIN lens (118) comprises a GRIN optical fiber (120) having the refractive index decreasing from the central longitudinal axis (202) to the perimeter edge (123).

3. The electronic device of claim 1, wherein the GRIN lens (118) has a first lens end (204) and a second lens end (206), and one or more of the first lens end (204) or the second lens end (206) are a flat plane.

4. The electronic device of claim 1, wherein the optical interconnects (112) comprise a waveguide proximate a surface of the PIC (106), the waveguide configured to guide the photonic signal transmitted through the GRIN lens (118).

5. The electronic device of claim 4, wherein:
the surface of PIC (106) comprises a first surface;
the PIC (106) includes an edge extending from the first surface; and
the GRIN lens (118) is coupled with the edge of the PIC (106).

6. The electronic device of claim 5, further comprising the one or more optical fibers (114,114A).

## Patentansprüche

1. Elektronische Vorrichtung (100), die Folgendes umfasst:
ein Substrat (102), das eine oder mehrere elektrische Leiterbahnen und ein dielektrisches Material enthält, wobei das Substrat einen Hohlraum aufweist, der dazu ausgelegt ist, eine oder mehrere Komponenten der elektronischen Vorrichtung (100) aufzunehmen;
eine photonische integrierte Schaltung, PIC, (106), die mit dem Substrat (102) gekoppelt ist, wobei die PIC (106) eine oder mehrere optische Zwischenverbindungen (112) enthält, wobei:
die PIC (106) dazu ausgelegt ist, ein photonisches Signal mit einer oder mehreren Lichtleitfasern (114) zu kommunizieren;
die PIC (106) dazu ausgelegt ist, das photonische Signal in ein elektronisches Signal zu verarbeiten; und
die PIC (106) sich zwischen einem ersten Ende und einem zweiten Ende erstreckt und das erste Ende der PIC sich in den Hohlraum erstreckt;
eine elektronische integrierte Schaltung, EIC, (108), die mit dem Substrat (102) gekoppelt ist, wobei die EIC (108) mit der PIC (106) kommuniziert und die EIC dazu ausgelegt ist, das elektronische Signal zu der PIC (106) zu senden oder das elektronische Signal von der PIC (106) zu empfangen; und
eine Linsenbaugruppe (116), die mindestens eine Linse (118) mit einem Gradientenbrechungsindex, GRIN, enthält, wobei:
die GRIN-Linse (118) eine zentrale Längsachse und eine Umfangskante aufweist; und
ein Brechungsindex der GRIN-Linse (118) von der zentralen Längsachse zur Umfangskante (123) abnimmt;
**dadurch gekennzeichnet, dass**
sie ferner eine Faserarrayeinheit, FAU, (124) umfasst, die eine sphärische FAU-Linse (126) enthält, wobei die FAU (124) ausgelegt ist, mit der einen oder den mehreren Lichtleitfasern (114, 114A) zu koppeln; und
dass sich die GRIN-Linse (118) in dem Hohlraum befindet.

2. Elektronische Vorrichtung nach Anspruch 1, wobei die GRIN-Linse (118) eine GRIN-Lichtleitfaser (120) umfasst, deren Brechungsindex von der zentralen Längsachse (202) bis zur Umfangskante (123) abnimmt.

3. Elektronische Vorrichtung nach Anspruch 1, wobei die GRIN-Linse (118) ein erstes Linsenende (204) und ein zweites Linsenende (206) besitzt und das erste Linsenende (204) und/oder das zweite Linsenende (206) eine flache Ebene sind.

4. Elektronische Vorrichtung nach Anspruch 1, wobei die optischen Zwischenverbindungen (112) einen Wellenleiter nahe einer Oberfläche der PIC (106) umfassen, wobei der Wellenleiter dazu ausgelegt ist, das photonische Signal zu leiten, das durch die GRIN-Linse (118) übertragen wird.

5. Elektronische Vorrichtung nach Anspruch 4, wobei:
die Oberfläche der PIC (106) eine erste Oberfläche umfasst;
die PIC (106) eine Kante aufweist, die sich von der ersten Oberfläche erstreckt;
und die GRIN-Linse (118) mit der Kante der PIC (106) gekoppelt ist.

6. Vorrichtung nach Anspruch 5, die ferner die eine oder die mehreren Lichtleitfasern (114, 114A) umfasst.

## Revendications

1. Dispositif électronique (100), comprenant :
un substrat (102) comportant une ou plusieurs traces électriques et un matériau diélectrique, le substrat comprenant une cavité configurée pour recevoir un ou plusieurs composants du dispositif électronique (100) ;
un circuit intégré photonique, PIC, (106) couplé au substrat (102), le PIC (106) comportant une ou plusieurs interconnexions optiques (112), dans lequel :
le PIC (106) est configuré pour échanger un signal photonique avec une ou plusieurs fibres optiques (114) ;
le PIC (106) est configuré pour transformer le signal photonique en un signal électronique ; et
le PIC (106) s'étend entre une première extrémité et une deuxième extrémité, et la première extrémité du PIC s'étend dans la cavité ;
un circuit intégré électronique, EIC, (108) couplé au substrat (102), dans lequel l'EIC (108) est en communication avec le PIC (106), et l'EIC est configuré pour transmettre le signal électronique au PIC (106) ou pour recevoir le signal électronique du PIC (106) ; et
un ensemble lentille (116) comprenant au moins une lentille (118) à gradient d'indice de réfraction, GRIN, dans lequel :
la lentille GRIN (118) présente un axe longitudinal central et un bord périphérique ; et
un indice de réfraction de la lentille GRIN (118) diminue depuis l'axe longitudinal central vers le bord périphérique (123),
**caractérisé en ce que**
il comprend en outre une unité de réseau de fibres, FAU, (124) comprenant une lentille de FAU sphérique (126), la FAU (124) étant configurée pour être couplée à la ou aux fibres optiques (114, 114A) ; et
**en ce que** la lentille GRIN (118) est dans la cavité.

2. Dispositif électronique selon la revendication 1, dans lequel la lentille GRIN (118) comprend une fibre optique GRIN (120) dont l'indice de réfraction diminue depuis l'axe longitudinal central (202) vers le bord périphérique (123).

3. Dispositif électronique selon la revendication 1, dans lequel la lentille GRIN (118) présente une première extrémité de lentille (204) et une seconde extrémité de lentille (206), et une ou plusieurs de la première extrémité de lentille (204) ou de la seconde extrémité de lentille (206) sont un plan plat.

4. Dispositif électronique selon la revendication 1, dans lequel les interconnexions optiques (112) comprennent un guide d'ondes à proximité d'une surface du PIC (106), le guide d'ondes étant configuré pour guider le signal photonique transmis à travers la lentille GRIN (118).

5. Dispositif électronique selon la revendication 4, dans lequel :
la surface du PIC (106) comprend une première surface ;
le PIC (106) comporte un bord s'étendant depuis la première surface ;
et la lentille GRIN (118) est couplée au bord du PIC (106).

6. Dispositif périphérique selon la revendication 5, comprenant en outre la ou les fibres optiques (114, 114A) .
